# EUROPEAN PATENT SPECIFICATION

(11) **EP 0 497 432 B1**
(45) Date of publication and mention of the grant of the patent: **19.07.1995**
(21) Application number: 92201061.6
(22) Date of filing: 13.04.1988
(51) Int. Cl.: H01S 3/133

(54) **An apparatus for driving a semiconductor laser device**
Apparat zum Betrieb einer Halbleiterlaservorrichtung
Appareil pour commander un dispositif à laser à semi-conducteur

(30) Priority: 13.04.1987 JP 90168/87; 13.04.1987 JP 90169/87; 13.04.1987 JP 90170/87; 13.04.1987 JP 90171/87; 13.04.1987 JP 90172/87; 05.02.1988 JP 25886/88; 09.03.1988 JP 55747/88
(43) Date of publication of application: 05.08.1992
(62) Divisional of application: 88303348.2
(73) Proprietor: SHARP KABUSHIKI KAISHA, Osaka 545 (JP)
(72) Inventor: Hatanaka, Kazuomi, Nara-ken (JP); Ohno, Takashi, Uda-gun, Nara-ken (JP); Ogou, Kenji, Nara-shi, Nara-ken (JP)
(74) Representative: White, Martin David

(56) References cited:
- EP-A- 0 061 034
- EP-A- 0 096 341
- CA-B- 1 210 070
- US-A- 4 692 606

## Description

### 1. Field of the invention:

This invention relates to an apparatus for driving a semiconductor laser device.

### 2. Description of the prior art:

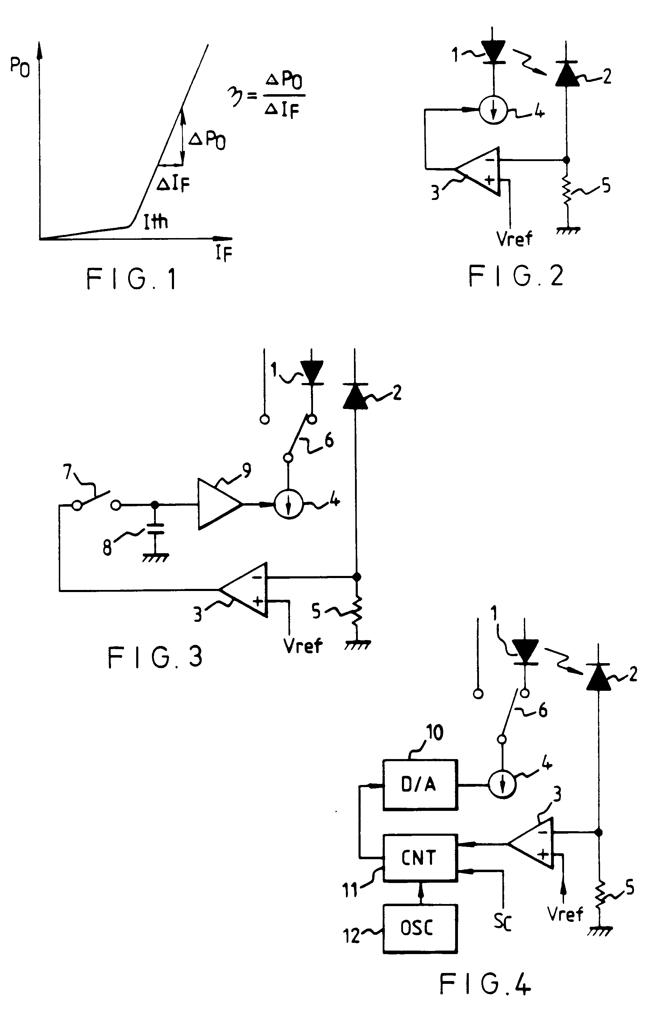

When driving a semiconductor laser device to obtain a laser beam, a forward current I_{F} is supplied to a pn junction in the laser device. The relationship between the forward current I_{F} and the optical output P_{O} of a semiconductor laser device is not linear. As the forward current I_{F} supplied to a semiconductor laser device increases, the laser device begins to oscillate a laser beam at a certain level of the current (a threshold current Iₜₕ). As the forward current I_{F} increases further, the laser output P_{O} also increases. Figure 1 shows an example of the relationship between the forward current I_{F} and the optical output P_{O} of a semiconductor laser device.

The level of a threshold current Iₜₕ and the rate of change in an optical output P_{O} with respect to the changes in a forward current I_{F} are not constant but vary according to an ambient temperature or to the individual semiconductor laser device. Such a rate of change in an optical output P_{O} is called a differential efficiency.

When a semiconductor laser diode is driven at an optical output of a constant level, the system shown in Fig. 2 is generally used. In this system, a semiconductor laser diode **1** is driven by a current source **4** which is controlled by the output of an amplifier **3**. The optical output of the laser diode **1** is monitored by a photodiode **2**, and is converted into voltage by a resistor **5**. The voltage is applied to one input terminal of the amplifier **3**. The system shown in Fig. 2 constitutes a negative feedback loop. A reference voltage V_{ref} is applied to the other input terminal of the amplifier **3** so that the optical output of the laser diode **1** is controlled to have a predetermined level corresponding to the reference voltage V_{ref}.

The system shown in Fig. 2 is used for obtaining a constant optical output of a predetermined level. In certain kinds of application of a semiconductor laser diode, such as laser printers or optical communication, a semiconductor laser diode producing a constant optical output of a predetermined level is turned on and off at a high speed. Figure 3 shows an example of a system used for such an application.

The system of Fig. 3 comprises, in addition to the components in the system of Fig. 2, an analog switch **7** and a capacitor **8** which constitute a sample-hold circuit. The system of Fig. 3 further comprises a high-speed switch **6** and a buffer amplifier **9**. The operation of the system of Fig. 3 will be described. First, the switch **6** is set to the right position, and the switch **7** is turned on to obtain an optical output of a predetermined level corresponding to the reference voltage V_{ref}. Thereafter, the switch **7** is turned off. At this stage, the voltage applied to the amplifier **9** is held at the voltage level of the capacitor **8** so that the driving current supplied to the laser diode **1** is maintained to be constant. Then, the switch **6** is turned off and on at a high speed, resulting in a high-speed switching of the optical output of a constant level.

With the system shown in Fig. 3, it is difficult to maintain the optical output at a constant level for a long period of time because the voltage of the capacitor **8** is an analog value. The system illustrated in Fig. 4 has been proposed to solve this problem, i.e., the system can maintain the optical output at a constant level for a long period of time.

The system of Fig. 4 is not provided with the sample-hold circuit (the analog switch **7** and capacitor **8**) and the buffer amplifier **9** which are used in the system of Fig. 3, but comprises an up/down counter **11**, a D/A converter **10**, and an oscillator **12**. In the system of Fig. 4, the amplifier **3** functions as a comparator. When the output of the comparator **3** is "HIGH", the up/down counter **11** counts up the output pulses of the oscillator **12**. When the output of the comparator **3** is "LOW", in contrast, the counter **11** counts down the output pulses of the oscillator **12**. The output of the counter **11** is converted into an analog value corresponding to the forward current I_{F} by the D/A converter **10**. When the switch **6** is set to the right position, the forward current I_{F} from the current source **4** is supplied to the semiconductor laser diode **1** to drive the laser diode **1**. The system of Fig. 4 constitutes a negative feedback loop so that the optical output of the laser diode 1 is regulated at a constant value corresponding to the reference voltage V_{ref}. An error which corresponds to one pulse of the output of the oscillator **12** may occur in the level of the optical output.

One problem is the fact that the I_{F}-P_{O} characeristics of a semiconductor laser diode are such that, if a foward current I_{F} is less than the threshold current Iₜₕ, laser oscillation does not occur. Accordingly, if the forward current I_{F} is less than the threshold current Iₜₕ, it cannot be used for control in driving the laser diode. For this reason, the quantization error of the optical output P_{O} is greater than the quantization error of the forward current I_{F}, resulting in less accuracy in controlling the optical output P_{O}.

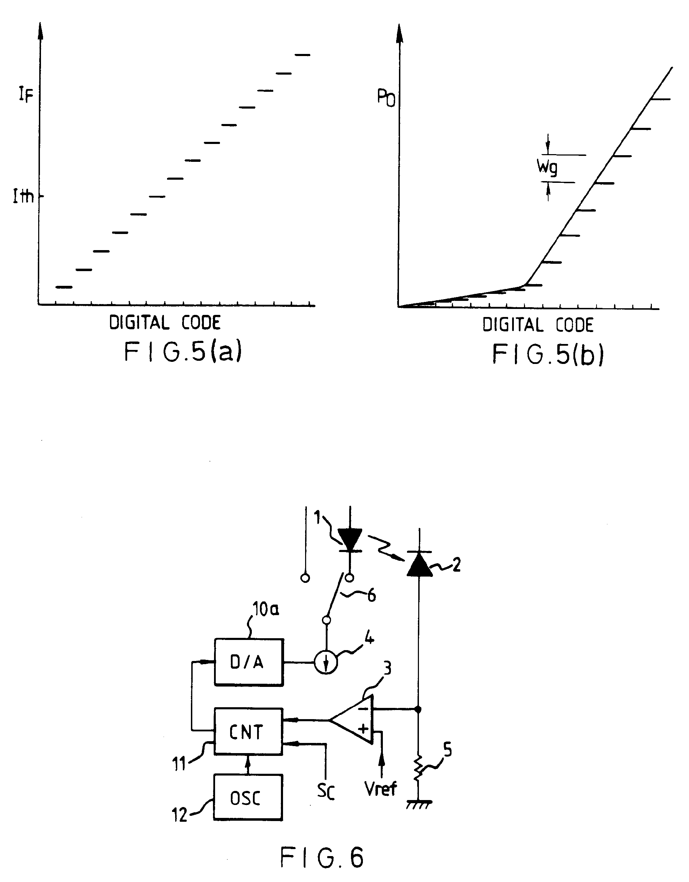

The above-mentioned problem will be discussed in more detail. Figure 5 (a) shows a relation between an input (digital codes) and an output (forward current I_{F}) of D/A converter which are usually used in a conventional system such as shown in Fig. 4. Figure 5 (b) shows a relation between optical outputs P_{O} of laser diode and digital codes in the conventional system of Fig. 4 which employs a D/A converter having the linear characteristics shown in Fig. 5 (a). The digital codes corresponding to values lower than the threshold current Iₜₕ of a laser diode do not contribute to the optical output of the laser diode. As shown in Fig. 5 (b), therefore, the range of the codes which are effective in practical use is restricted, resulting in a reduced effective resolution of the D/A converter 10. In Fig. 5 (b), "W_{q}" indicates a quantization width of the optical output P_{O}.

CA-B-1 210 070 discloses a controller for supplying a bias current (I) to a laser used in a digital data transmission system. The controller measures the second derivative of the laser output power (L) with respect to the bias current. The controller sets the bias current at a value corresponding to a peak in d²L/dI², as this value of the bias current maximises the ratio of the laser output power for data "1" to the laser output power for data "0".

CA-B-1 210 070 does not disclose a controller which can operate a laser device at a predetermined optical output.

According to the present invention there is provided an apparatus for driving a semiconductor laser device to develop a predetermined constant optical output, said apparatus comprising means for monitoring an optical output of the laser device and generating a signal which is representative of the optical output and a feedback loop comprising:- comparing means for comparing said signal representative of the optical output with a reference value and providing an output signal, said output signal depending on a comparison of said signal representative of the optical output with said reference value; counting means for developing a digital signal for said output signal being provided from said comparing means; D/A converting means for developing a control signal in response to said digital signal; and current supply means for driving the laser device at said predetermined optical output in response to said first control signal; said apparatus being characterised in that said D/A converting means has a non-linear characteristic.

According to the present invention there is further provided an apparatus for driving a semiconductor laser device to develop a predetermined constant optical output, said apparatus comprising means for monitoring an optical output of the laser device and generating a signal which is representative of the optical output and a feedback loop comprising:- comparing means for comparing said signal representative of the optical output with a reference value and providing an output signal, said output signal depending on a comparison of said signal representative of the optical output with said reference value; counting means for developing a digital signal for said output signal being provided from said comparing means; D/A converting means for developing a control signal in response to said digital signal; and current supply means for driving the laser device at said predetermined optical output in response to said first control signal; said apparatus being characterised in that said D/A converting means provides an offset output.

Thus, the invention described herein makes possible the objective of providing an apparatus for driving a semiconductor laser device which can control an optical output level with high accuracy.

This invention may be better understood and its numerous objects and advantages will become apparent to those skilled in the art by reference to the accompany drawings as follows:

Figure 1 is a graph showing a relation between a forward current I_{F} and an optical output level of a laser diode.

Figure 2 is a diagram showing an example of a conventional apparatus.

Figure 3 is a diagram showing another example of a conventional apparatus in which a sample-hold circuit is used and the optical output of a laser diode is switched at a high frequency.

Figure 4 is a diagram showing a further example of a conventional apparatus in which a D/A converter is disposed in a feedback loop.

Figures 5 (**a**) and 5(**b**) are respectively a graph showing a relation between digital codes and the forward current and a graph showing a relation between digital codes and the optical output of the laser diode, according to the conventional example shown in Fig. 4.

Figure 6 is a diagram showing one embodiment of the invention.

Figures 7 (**a**) and 7 (**b**) are graphs similar to Figs. 5(a) and 5 (b), according to the embodiment shown in Fig. 6.

Figure 8 is a diagram showing a further embodiment of the invention.

Figures 9 (**a**) and 9 (**c**) are respectively a graph showing an example of relation between digital codes and the forward current and a graph showing a relation between digital codes and the optical output of the laser diode, according to the embodiment shown in Fig. 8.

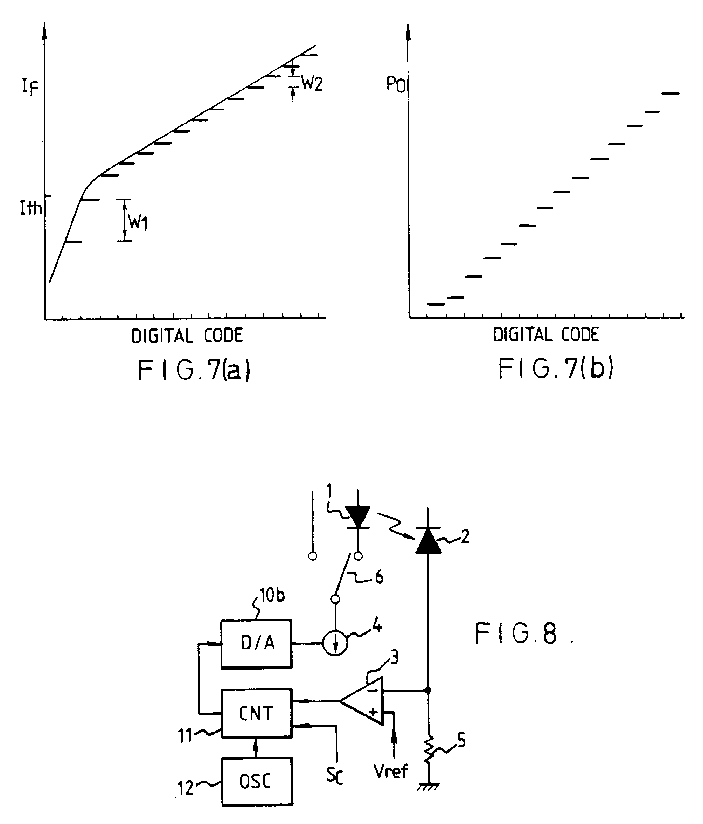

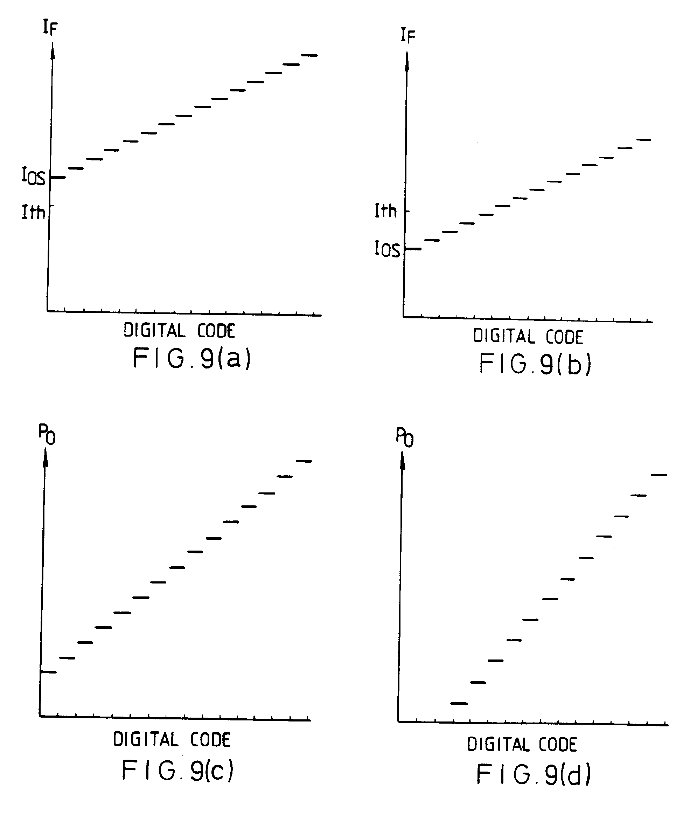

Figures 9 (**b**) and 9 (**d**) are respectively a graph showing another example of relation between digital codes and the forward current and a graph showing a relation between digital codes and the optical output of the laser diode, according to the embodiment shown in Fig. 8.

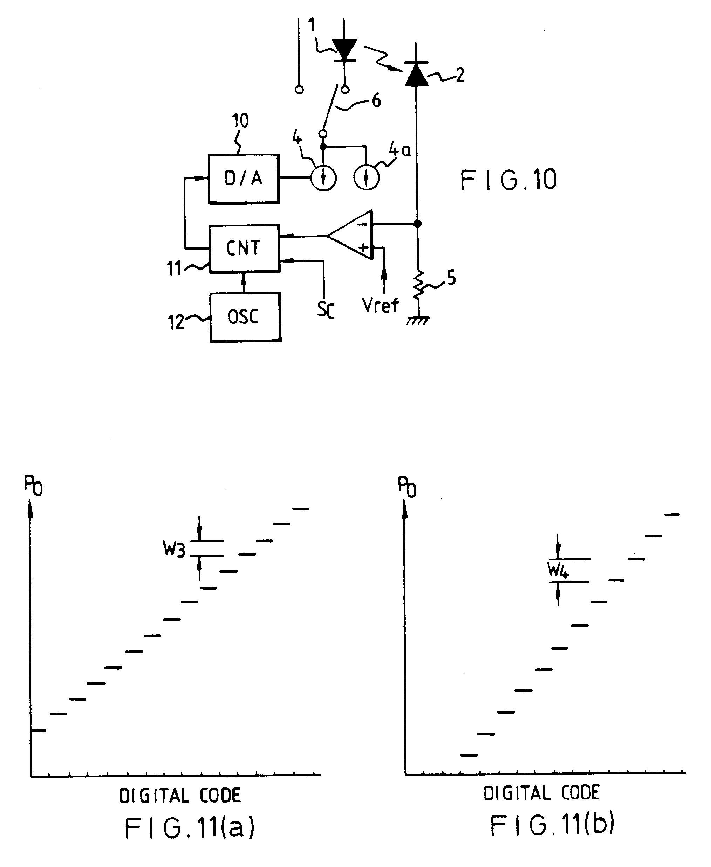

Figure 10 is a diagram showing a further embodiment of the invention.

Figures 11 (**a**) and 11(**b**) are graphs showing relations between digital codes and the optical output of the laser diode, according to the embodiment shown in Fig. 10.

Figure 6 shows an embodiment of the invention. The configuration of the system shown in Fig. 6 is similar to that of the system of Fig. 4, but employs a D/A converter **10a** having non-linear characteristics instead of the converter **10** in the system of Fig. 4. The relation between an input (digital codes) and an output (forward current I_{F}) of the D/A converter **10a** in this embodiment is shown in Fig. 7(**a**). In the range wherein the forward current I_{F} is smaller than the threshold current Iₜₕ, the quantization width W₁ is wide, and in the range wherein the forward current I_{F} is larger than the threshold current Iₜₕ, the quantization width W₂ is narrow.

Figure 7 (**b**) shows a relation between optical output P_{O} and the digital codes of the D/A converter **10a** in this embodiment. Because of the non-linear characteristics of the converter **10a**, the number of the digital codes which correspond to the current levels lower than the threshold current Iₜₕ is small, compared to that of the conventional system which is shown in Fig. 5. In other words, the number of the codes which are effective in the control of the optical output of the laser diode is large even when the D/A converter **10a** has the same number of digital codes as that of the D/A converter **10** of Fig. 4, resulting in an improved effective resolution of the D/A converter **10a** and also in a very accurate control of the optical output.

Figure 8 shows a further embodiment of the invention. The configuration of the system shown in Fig. 8 is similar to that of the system of Fig. 6, but employs a D/A converter **10b** having a characteristic that an offset current of a certain level flows when the digital code is zero. In an example of the characteristic shown in Fig. 9 (**a**), the offset current I_{OS} is greater than the threshold current Iₜₕ. In another example shown in Fig. 9 (**b**), the offset current I_{OS} is smaller than the threshold current Iₜₕ. The relation between an input (digital code) and an output (forward current I_{F}) of the D/A converter **10b** having the characteristics of Fig. 9 (**a**) is shown in Fig. 9 (**c**), and that of the D/A converter **10b** having the characteristics of Fig. 9 (**b**) is shown in Fig. 9(**d**). There is no digital codes in the range lower than the threshold current Iₜₕ (Fig. 9 (**a**)), or there is a small number of digital codes in the range lower than the threshold current Iₜₕ (Fig. 9 (**b**)). Namely, the number of the codes which are effective in the control of the optical output of the laser diode is large even when the D/A converter **10b** has the same number of digital codes as that of the D/A converter **10** of Fig. 4, resulting in an improved effective resolution of the D/A converter **10b** and also in a very accurate control of the optical output.

Figure 10 shows a further embodiment of the invention. The configuration of the system shown in Fig. 10 is similar to that of the system of Fig. 4 except that a second current source **4a** is provided. The current source **4a** supplies an offset current I_{OS} of a certain level to the laser diode **1**, i.e., the laser diode **1** is driven by the sum of the forward current I_{F} and the offset current I_{OS}. Figures 11 (**a**) and 11 (**b**) show the relations between digital codes of the D/A converter **10** and optical outputs P_{O} of the laser diode **1** when the offset current I_{OS} is greater or smaller than the threshold current Iₜₕ, respectively. When the offset current I_{OS} is smaller than the threshold current Iₜₕ, the number of the codes which are ineffective in the control of the optical output of the laser diode **1** is small (Fig. 11 (**b**)). When the offset current I_{OS} is greater than the threshold current Iₜₕ, there is no code which is ineffective in the control of the optical output of the laser diode **1** (Fig. 11(**a**)). Consequently, the quantization widths **W₃** (Fig. 11 (**a**)) or **W₄** (Fig. 11(**b**)) in the system of Fig. 10 is narrow, compared to those obtained by the system of Fig. 4 even when the D/A converters **10** used in both the systems have the same resolution characteristics, resulting in an improved effective resolution of the D/A converter **10** and also in a very accurate control of the optical output.

As seen from the above-mentioned description of the preferred embodiments, a D/A converter having low resolution which can be easily produced at a low cost can be used in an apparatus of the present invention. Therefore, an apparatus of the present invention can be easily manufactured a low cost and is easily integrated.

It is understood that various other modifications will be apparent to and can be readily made by those skilled in the art without departing from the scope of this invention. Accordingly, it is not intended that the scope of the invention be limited to the detailed description as set forth above, but rather by the scope of the appended claims.

## Claims

1. An apparatus for driving a semiconductor laser device (1) to develop a predetermined constant optical output, said apparatus comprising means (2) for monitoring an optical output of the laser device (1) and generating a signal which is representative of the optical output and a feedback loop comprising:-
comparing means (3) for comparing said signal representative of the optical output with a reference value and providing an output signal, said output signal depending on a comparison of said signal representative of the optical output with said reference value;
counting means (11) for developing a digital signal for said output signal being provided from said comparing means (3);
D/A converting means (10a) for developing a control signal in response to said digital signal; and
current supply means (4) for driving the laser device (1) at said predetermined optical output in response to said control signal;
said apparatus being characterised in that said D/A converting means (10a) has a non-linear characteristic.

2. An apparatus for driving a semiconductor laser device (1) to develop a predetermined constant optical output, said apparatus comprising means (2) for monitoring an optical output of the laser device (1) and generating a signal which is representative of the optical output and a feedback loop comprising:-
comparing means (3) for comparing said signal representative of the optical output with a reference value and providing an output signal, said output signal depending on a comparison of said signal representative of the optical output with said reference value;
counting means (11) for developing a digital signal for said output signal being provided from said comparing means (3);
D/A converting means (10b) for developing a control signal in response to said digital signal; and
current supply means (4) for driving the laser device (1) at said predetermined optical output in response to said control signal;
said apparatus being characterised in that said D/A converting means (10b) provides an offset output.

3. An apparatus for driving a semiconductor laser device (1) to develop a predetermined constant optical output, said apparatus comprising means (2) for monitoring an optical output of the laser device (1) and generating a signal which is representative of the optical output and a feedback loop comprising:-
comparing means (3) for comparing said signal representative of the optical output with a reference value and providing an output signal, said output signal depending on a comparison of said signal representative of the optical output with said reference value;
counting means (11) for developing a digital signal for said output signal being provided from said comparing means (3);
D/A converting means (10) for developing a control signal in response to said digital signal; and
first current supply means (4) for driving the laser device (1) at said predetermined optical output in response to said control signal;
said apparatus being characterised in that it further comprises second current supply means (4a) for supplying current to said laser device (1), said second current supply means (4a) not being within said feedback loop.

## Patentansprüche

1. Vorrichtung zum Betreiben eines Halbleiterlaser-Bauteils (1) zum Erzeugen einer vorgegebenen konstanten optischen Ausgangsleistung, die folgendes aufweist: eine Einrichtung (2) zum Überwachen der optischen Ausgangsleistung des Laserbauteils (1) und zum Erzeugen eines Signals, das für die optische Ausgangsleistung repräsentativ ist, und mit einer Rückkopplungsschleife, die folgendes aufweist:
- eine Vergleichseinrichtung (3) zum Vergleichen des für die optische Ausgangsleistung repräsentativen Signals mit einem Bezugswert und zum Erstellen eines Ausgangssignals, das vom Vergleich des für die optische Ausgangsleistung repräsentativen Signals mit dem Bezugswert abhängt;
- eine Zähleinrichtung (11) zum Erzeugen eines digitalen Signals für das von der Vergleichseinrichtung (3) gebildete Ausgangssignal;
- eine D/A-Umsetzeinrichtung (10a) zum Erzeugen eines Steuersignals auf dieses digitale Signal hin; und
- eine Stromversorgungseinrichtung (4) zum Betreiben des Laserbauteils (1) mit der vorgegebenen optischen Ausgangsleistung auf das Steuersignal hin;
**dadurch gekennzeichnet, daß** die D/A-Umsetzeinrichtung (10a) eine nichtlineare Charakteristik aufweist.

2. Vorrichtung zum Betreiben eines Halbleiterlaser-Bauteils (1) zum Erzeugen einer vorgegebenen konstanten optischen Ausgangsleistung, die folgendes aufweist: eine Einrichtung (2) zum Überwachen der optischen Ausgangsleistung des Laserbauteils (1) und zum Erzeugen eines Signals, das für die optische Ausgangsleistung repräsentativ ist, und mit einer Rückkopplungsschleife, die folgendes aufweist:
- eine Vergleichseinrichtung (3) zum Vergleichen des für die optische Ausgangsleistung repräsentativen Signals mit einem Bezugswert und zum Erstellen eines Ausgangssignals, das vom Vergleich des für die optische Ausgangsleistung repräsentativen Signals mit dem Bezugswert abhängt;
- eine Zähleinrichtung (11) zum Erzeugen eines digitalen Signals für das von der Vergleichseinrichtung (3) gebildete Ausgangssignal;
- eine D/A-Umsetzeinrichtung (10a) zum Erzeugen eines Steuersignals auf dieses digitale Signal hin; und
- eine Stromversorgungseinrichtung (4) zum Betreiben des Laserbauteils (1) mit der vorgegebenen optischen Ausgangsleistung auf das Steuersignal hin;
**dadurch gekennzeichnet, daß** die D/A-Umsetzeinrichtung (10b) ein Offset-Ausgangssignal liefert.

3. Vorrichtung zum Betreiben eines Halbleiterlaser-Bauteils (1) zum Erzeugen einer vorgegebenen konstanten optischen Ausgangsleistung, die folgendes aufweist: eine Einrichtung (2) zum Überwachen der optischen Ausgangsleistung des Laserbauteils (1) und zum Erzeugen eines Signals, das für die optische Ausgangsleistung repräsentativ ist, und mit einer Rückkopplungsschleife, die folgendes aufweist:
- eine Vergleichseinrichtung (3) zum Vergleichen des für die optische Ausgangsleistung repräsentativen Signals mit einem Bezugswert und zum Erstellen eines Ausgangssignals, das vom Vergleich des für die optische Ausgangsleistung repräsentativen Signals mit dem Bezugswert abhängt;
- eine Zähleinrichtung (11) zum Erzeugen eines digitalen Signals für das von der Vergleichseinrichtung (3) gebildete Ausgangssignal;
- eine D/A-Umsetzeinrichtung (10a) zum Erzeugen eines Steuersignals auf dieses digitale Signal hin; und
- eine erste Stromversorgungseinrichtung (4) zum Betreiben des Laserbauteils (1) mit der vorgegebenen optischen Ausgangsleistung auf das Steuersignal hin;
**dadurch gekennzeichnet, daß** die Vorrichtung ferner eine zweite Stromversorgungseinrichtung (4a) zum Zuführen von Strom zum Laserbauteil (1) aufweist, die nicht innerhalb der Rückkopplungsschleife liegt.

## Revendications

1. Appareil pour commander un dispositif laser à semi-conducteur (1) afin de développer une sortie optique constante prédéterminée, ledit appareil comprenant un moyen (2) destiné à contrôler une sortie optique du dispositif laser (1) et à générer un signal représentatif de la sortie optique, et une boucle de réaction comprenant :
un moyen comparateur (3) destiné à comparer ledit signal représentatif de la sortie optique avec une valeur de référence et à fournir un signal de sortie, ledit signal de sortie étant fonction d'une comparaison dudit signal représentatif de la sortie optique avec ladite valeur de référence ;
un moyen de comptage (11) destiné à développer un signal numérique pour ledit signal de sortie fourni à partir dudit moyen comparateur (3) ;
un moyen convertisseur numérique/analogique (10a) destiné à développer un signal de commande en réponse audit signal numérique ; et
un moyen d'alimentation en courant (4) destiné à commander le dispositif laser (1) selon ladite sortie optique prédéterminée en réponse audit signal de commande ;
ledit appareil étant caractérisé en ce que ledit moyen convertisseur numérique/analogique (10a) a une caractéristique non linéaire.

2. Appareil pour commander un dispositif laser à semi-conducteur (1) afin de développer une sortie optique constante prédéterminée, ledit appareil comprenant un moyen (2) destiné à contrôler une sortie optique du dispositif laser (1) et à générer un signal représentatif de la sortie optique, et une boucle de réaction comprenant :
un moyen comparateur (3) destiné à comparer ledit signal représentatif de la sortie optique avec une valeur de référence et à fournir un signal de sortie, ledit signal de sortie étant fonction d'une comparaison dudit signal représentatif de la sortie optique avec ladite valeur de référence ;
un moyen de comptage (11) destiné à développer un signal numérique pour ledit signal de sortie fourni à partir dudit moyen comparateur (3) ;
un moyen convertisseur numérique/analogique (10b) destiné à développer un signal de commande en réponse audit signal numérique ; et
un moyen d'alimentation en courant (4) destiné à commander le dispositif laser (1) selon ladite sortie optique prédéterminée en réponse audit signal de commande ;
ledit appareil étant caractérisé en ce que ledit moyen convertisseur numérique/analogique (10b) fournit une sortie décalée.

3. Appareil pour commander un dispositif laser à semi-conducteur (1) afin de développer une sortie optique constante prédéterminée, ledit appareil comprenant un moyen (2) destiné à contrôler une sortie optique du dispositif laser (1) et à générer un signal représentatif de la sortie optique, et une boucle de réaction comprenant :
un moyen comparateur (3) destiné à comparer ledit signal représentatif de la sortie optique avec une valeur de référence et à fournir un signal de sortie, ledit signal de sortie étant fonction d'une comparaison dudit signal représentatif de la sortie optique avec ladite valeur de référence ;
un moyen de comptage (11) destiné à développer un signal numérique pour ledit signal de sortie fourni à partir dudit moyen comparateur (3) ;
un moyen convertisseur numérique/analogique (10) destiné à développer un signal de commande en réponse audit signal numérique ; et
un premier moyen d'alimentation en courant (4) destiné à commander le dispositif laser (1) selon ladite sortie optique prédéterminée en réponse audit signal de commande ;
ledit appareil étant caractérisé en ce qu'il comprend, en outre, un second moyen d'alimentation en courant (4a) destiné à fournir un courant audit dispositif laser (1), ledit second moyen d'alimentation en courant (4a) ne faisant pas partie de ladite boucle de réaction.
